# EUROPEAN PATENT SPECIFICATION

(11) **EP 2 913 422 B1**
(45) Date of publication and mention of the grant of the patent: **01.04.2020**
(21) Application number: 12887060.7
(22) Date of filing: 23.10.2012
(51) Int. Cl.: C23C 14/34, C23C 14/06, C23C 14/10, H01J 37/32, H01J 37/34, C23C 14/00, C23C 14/35

(54) **THIN FILM FORMATION APPARATUS AND METHOD OF FORMING THIN FILM**
DÜNNSCHICHTBILDUNGSVORRICHTUNG UND VERFAHREN ZUR HERSTELLUNG EINER DÜNNSCHICHT
APPAREIL DE FORMATION DE COUCHE MINCE ET PROCÉDÉ DE FORMATION DE COUCHE MINCE

(43) Date of publication of application: 02.09.2015
(73) Proprietor: Shincron Co., Ltd., Kanagawa 220-8680 (JP)
(72) Inventor: MIYAUCHI, Mitsuhiro, Yokohama-shi Kanagawa 220-8680 (JP); MURATA, Takanori, Yokohama-shi Kanagawa 220-8680 (JP); SUGAWARA, Takuya, Yokohama-shi Kanagawa 220-8680 (JP); SHIONO, Ichiro, Yokohama-shi Kanagawa 220-8680 (JP); JIANG, Yousong, Yokohama-shi Kanagawa 220-8680 (JP); HAYASHI, Tatsuya, Yokohama-shi Kanagawa 220-8680 (JP); NAGAE, Ekishu, Yokohama-shi Kanagawa 220-8680 (JP)
(74) Representative: Grünecker Patent- und Rechtsanwälte PartG mbB
(86) International application number: PCT/JP2012/077345
(87) International publication number: WO 2014/064768

(56) References cited:
- EP-A1- 1 640 474
- WO-A1-96/34125
- WO-A1-2004/108980
- JP-A- S62 211 378
- JP-A- 2002 512 656
- US-A- 4 405 989
- US-A1- 2004 074 769
- US-A1- 2007 181 421

## Description

### Technical Field

The present invention relates to a thin film formation apparatus, a sputtering cathode, and a method of forming a thin film and, in particular, to a thin film formation apparatus, a sputtering cathode, and a method of forming a thin film, capable of forming an optical multilayer film on a substrate at a high film deposition rate.

### Background Art

WO 96/34125 A1 relates to a sputtering device having a vacuum chamber, a means for transporting a plurality of substrates and an inlet for introducing sputtering gas. EP 1 640 474 A1 and US 2004/074769 A1 relate to a thin film forming device and a thin film forming method. US 4 405 989 A relates to a spectral monitoring device for sputtering.

As a method of forming a thin film of a metal compound by sputtering, an RF reactive sputtering method, where a thin film is formed by reactive sputtering using a high frequency power source to introduce a reactive gas to a metal compound target or a metal target, a DC reactive sputtering method, where a thin film is formed by reactive sputtering using a DC power supply to introduce a reactive gas to a metal compound target or a metal target, and the like are known.

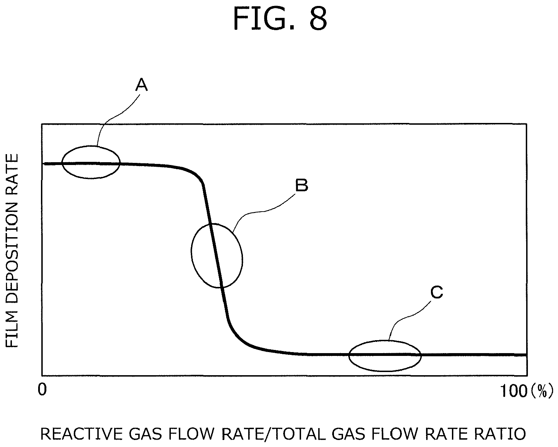

A relation between a reactive gas flow rate/total gas flow rate ratio and a film deposition rate (rate of forming thin film) is shown in Fig.8. The reactive gas flow rate and the total gas flow rate in Fig.8 are a gas flow rate measured in the vicinity of the target. In Fig.8, a region having the low reactive gas flow rate ratio is called as a metal mode A, in which the film deposition rate is substantially equal to the case where the reactive gas flow rate is zero. In the region of the metal mode, the film deposition rate is insensitive to variations of the reactive gas flow rate values.

In a region where the reactive gas flow rate ratio is higher than the metal mode, the film deposition rate decreases rapidly as the reactive gas flow rate ratio increases, the region referred to as a transitional region mode B. As the reactive gas flow rate ratio further increases, the film deposition rate is stabilized at a low level, entering a reactive mode C, where the film deposition rate is again insensitive to variations of the reactive gas flow rate values.

In the above-mentioned RF reactive sputtering method and DC reactive sputtering method, the sputtering is performed in the region of the reactive mode C in the graph of Fig.8, resulting in having about 1/5 to 1/10 of the film deposition rate when compared with the case of forming a metal thin film without introducing the reactive gas.

As a technique for forming an optical multilayer film with high quality while solving the problem of the low film deposition rate observed in the RF reactive sputtering method and the DC reactive sputtering method, there is a known sputtering method, in which a radical source is provided in a vacuum chamber, whereby sputter particles from a metal target, and deposits on a substrate are converted by radicals through oxidation or the like to form metal compounds (e.g., see Patent Document 1).

In the sputtering method described in Patent Document 1, a film deposition area and a reaction area are separated spatially as well as in a pressure-wise manner in a vacuum chamber, so that after the sputtering is performed with a metal target in the film deposition area, the thus formed metal thin film is brought into contact with an active species of a reactive gas in the reaction area to form a thin film of a metal compound.

According to the sputtering method described in Patent Document 1, an optical multilayer film can be formed at a high film deposition rate since the film formation is performed in the metal mode A, instead of the reactive mode C in Fig.8.

However, according to the sputtering method of Patent Document 1, the film deposition area where the sputtering is performed and the reaction area where oxidation and nitriding occur by the radicals need to be spatially separated, and further, the high-speed rotation of the substrate is required, thus, a type of sputtering apparatus used in this method is limited to a carousel type rotary drum. This method, therefore, couldn't be applied to an opposed-to-substrate type or in-line type sputtering apparatus. As such, a substrate that can be mounted is limited to the one with a small size, and it has been difficult to form a film on a large-sized substrate.

### CITATION LIST

### PATENT DOCUMENT

Patent Document 1: JP 2001-234338 A (Paragraphs 0067-0072 and Fig.1)

### DISCLOSURE OF THE INVENTION

### Problem to be Solved by the Invention

The present invention has been made in view of the above-described problems, and an object of the present invention is to provide a thin film formation apparatus, a sputtering cathode, and a method of forming a thin film, capable of forming an optical multilayer film on a large-sized substrate at a high film deposition rate.

### Means for Solving Problem

As a result of an extensive study on the arrangement of a target and an active species source in a vacuum chamber, the present inventors surprisingly found that it is possible to form a thin film of a metal compound by sputtering in the metal mode or the transitional region mode instead of the reactive mode by arranging an energy source for exciting a reactive gas into a plasma state in a defined position despite that the target and the active species source are not separated spatially or in a pressure-wise manner, but rather arranged to produce mutual electromagnetic and pressure interactions, and were able to complete the present invention.

That is, the above-mentioned problems can be solved by a thin film formation apparatus for forming a thin film of a metal compound on a substrate in a vacuum chamber by sputtering according to claim 1, wherein the thin film formation apparatus includes in the vacuum chamber a target composed of metal or a conductive metal compound, and an active species source for generating an active species of a reactive gas, arranged to produce mutual electromagnetic and pressure interactions with the target, the active species source includes a gas source for supplying the reactive gas, and an energy source for exciting the reactive gas into a plasma state by supplying an energy within the vacuum chamber, the energy source includes between itself and the vacuum chamber a dielectric window for supplying the energy within the vacuum chamber, and the dielectric window is disposed in such a way as inclining towards the target side with an angle of less than 90° to the substrate.

In a conventional reactive sputtering, where a target such as metal is sputtered while a reactive gas is introduced, a metal compound is formed on the surface of the target as the introduction rate of the reactive gas increases, so that film formation is performed in the reactive mode with a low film deposition rate. In contrast, in the thin film formation method of the present invention, a metal compound is deposited on a film by sputtering in the metal or transitional region mode instead of the reactive mode, thus an optical multilayer film can be formed at a high film deposition rate.

That is, because the active species source is arranged to produce mutual electromagnetic and pressure interactions with the target, this configuration creates plasma interactions between a plasma generated by applying a voltage to the target and a plasma generated by the active species source, and thereby increases the plasma density in the area between the target and the substrate. As the result, the amount of the sputtering gas active species such as Ar⁺ increases in the vicinity of the target and the sputtering efficiency is improved.

Further, because of the improvement of the sputtering efficiency, metal or a conductive metal compound is ejected from the target surface before a metal compound is formed on the target surface. Thus, formation of the metal compound is suppressed on the target surface, and the film deposition rate is prevented from being decreased.

Further, the active species of the reactive gas is generated by the active species source, thus making it possible to achieve a high reaction efficiency using a small amount of the reactive gas. As the result, even if the introduction rate of the reactive gas is reduced, a particle that is not a complete compound and ejected from the target, and a thin film-shaped product that is not a complete compound and formed by the accumulation of such particle on the substrate can be brought into a sufficient reaction. In this way, a thin film of a metal compound can be formed in the metal or transitional region mode.

Further, the energy source includes between itself and the vacuum chamber a dielectric window for supplying energy within the vacuum chamber, and the dielectric window is disposed in parallel with the substrate, or in such a way as inclining towards the target side with an angle of less than 90° to the substrate. Thus, it becomes possible to disperse a particle that is not a complete compound and ejected from the target composed of metal or a conductive metal compound by sputtering in the direction toward the substrate, and in the same time, convert a thin film-shaped product that is not a complete compound and formed by the accumulation of the particle that is not a complete compound on the substrate to a complete metal compound. As the result, it becomes unnecessary to separate spatially as well as in a pressure-wise manner between the target and the active species source, and they can be instead arranged to produce mutual electromagnetic and pressure interactions.

In this configuration, the vacuum chamber may internally include a substrate conveyance section for conveying a substrate, and the active species source may be disposed on at least one of the upstream and downstream sides of the target in a substrate conveyance direction.

By having the active species source disposed on at least one of the upstream and downstream sides of the target, it becomes possible to disperse a particle that is not a complete compound and ejected from the target composed of metal by sputtering in the direction toward the substrate, and in the same time, convert a thin film-shaped product that is not a complete compound and formed by the accumulation of the particle that is not a complete compound on the substrate to a complete metal compound. It also becomes unnecessary to separate spatially as well as in a pressure-wise manner between the target and the active species source, and they can be instead arranged to produce mutual electromagnetic and pressure interactions.

In this configuration, the energy source may be a plasma source for generating plasma by inductive coupling and surface wave through the dielectric window.

Having such configuration makes it possible to appropriately select a positional relation of a radical source relative to the substrate and the target, and readily constitute a thin film formation apparatus capable of forming a film at optimum conditions.

In this configuration, the active species source may be an inductive coupling type plasma (ICP) radical source.

Having such configuration makes it possible to achieve a high film deposition rate by large diameter plasma having low pressure and high density.

In this configuration, the thin film formation apparatus may comprises an in-line type sputtering apparatus having a plurality of film-forming stations including the target and the active species source disposed on at least one of the upstream and downstream sides of the target in the substrate conveyance direction.

Having such configuration makes it possible to constitute an apparatus for forming a thin film of a metal compound by sputtering with a high film deposition rate in the metal or transitional region mode without a need of adopting a carousel type as before. As the result, it becomes possible to form a thin film of a metal compound on a large-sized substrate with a high film deposition rate without limiting the shape and the size of a substrate.

In this configuration, the film-forming station may include a detection unit for optically detecting a film deposition rate, and a control unit for controlling the film deposition rate in each film-forming station accordingly by receiving a signal from the corresponding film deposition rate detection unit.

Having such configuration makes it possible to perform a feedback control of the film deposition rate, for example, by independently controlling a power source and a gas flow rate for sputtering, and a power source and a gas flow rate of the active species source.

In addition, the thin film formation apparatus preferably includes a sputtering section in the vacuum chamber for sputtering the target and by the sputtering dispersing a particle that is not a complete compound from the target to a substrate, and a composition conversion section in the vacuum chamber for converting the particle to a complete metal compound by contacting the particle with an active species of a reactive gas generated by the active species source, thereby making it possible to form a thin film composed of the complete metal compound on the substrate.

Having such configuration makes it possible to dispose the target and the active species source to produce mutual electromagnetic and pressure interactions and obviate the need for separating spatially as well as in a pressure-wise manner between the target and the active species source, thus enabling to provide a thin film formation apparatus with a simple constitution.

In a conventional reactive sputtering, where a target such as metal is sputtered while a reactive gas is introduced, a metal compound is formed on the surface of the target as the introduction rate of the reactive gas increases, so that film formation is performed in the reactive mode with a low film deposition rate. In contrast, in the thin film formation method of the present invention, a metal compound is deposited on a film by sputtering in the metal or transitional region mode instead of the reactive mode, thus an optical multilayer film can be formed at a high film deposition rate.

That is, because the active species source is arranged to produce mutual electromagnetic and pressure interactions with the target, this configuration creates plasma interactions between a plasma generated by applying a voltage to the target and a plasma generated by the active species source, and thereby increases the plasma density in the area between the target and the substrate. As the result, the amount of the sputtering gas active species such as Ar⁺ increases in the vicinity of the target and the sputtering efficiency is improved.

Further, because of the improvement of the sputtering efficiency, metal or a conductive metal compound is ejected from the target surface before a metal compound is formed on the target surface. Thus, formation of the metal compound is suppressed on the target surface, and the film deposition rate is prevented from being decreased.

Further, the active species of the reactive gas is generated by the active species source, thus making it possible to achieve a high reaction efficiency using a small amount of the reactive gas. As the result, even if the introduction rate of the reactive gas is reduced, a particle that is not a complete compound and ejected from the target, and a thin film-shaped product that is not a complete compound and formed by the accumulation of such particle on the substrate can be brought into a sufficient reaction. In this way, a thin film of a metal compound can be formed in the metal or transitional region mode.

In addition, the target and the active species source may be arranged side by side in the same space of a vacuum chamber in such a way that the sputtering face of the target where erosion occurs and the active species source are arranged to be opposed to the substrate, and the active species source are disposed on at least one of the upstream and downstream sides of the target in the substrate conveyance direction.

Having such configuration creates plasma interactions between plasma generated by applying a voltage to the target and plasma generated by the active species source, and increases the plasma density in the area between the target and the substrate, so that the amount of Ar⁺ increases in the vicinity of the target and the sputtering efficiency can be improved.

The above-mentioned problems can be solved by a method of forming a thin film according to claim 12, wherein the method comprises a sputtering step for sputtering a target composed of metal or a conductive metal compound and by the sputtering, dispersing a particle that is not a complete compound from the target to a substrate in a vacuum chamber, and a composition conversion step for converting the particle to a complete metal compound by contacting the particle with an active species of a reactive gas generated by an active species source arranged to produce mutual electromagnetic and pressure interactions with the target in the vacuum chamber, thereby enabling to form a thin film composed of the complete metal compound on the substrate.

In a conventional reactive sputtering, where a target such as metal is sputtered while a reactive gas is introduced, a metal compound is formed on the surface of the target as the introduction rate of the reactive gas increases, so that film formation is performed in the reactive mode with a low film deposition rate. In contrast, in the thin film formation method of the present invention, a metal compound is deposited on a film by sputtering in the metal or transitional region mode instead of the reactive mode, thus an optical multilayer film can be formed at a high film deposition rate.

That is, because the active species source is arranged to produce mutual electromagnetic and pressure interactions with the target, this configuration creates plasma interactions between a plasma generated by applying a voltage to the target and a plasma generated by the active species source, and thereby increases the plasma density in the area between the target and the substrate. As the result, the amount of the sputtering gas active species such as Ar⁺ increases in the vicinity of the target and the sputtering efficiency is improved.

Further, because of the improvement of the sputtering efficiency, metal or a conductive metal compound is ejected from the target surface before a metal compound is formed on the target surface. Thus, formation of the metal compound is suppressed on the target surface, and the film deposition rate is prevented from being decreased.

Further, the active species of the reactive gas is generated by the active species source, thus making it possible to achieve a high reaction efficiency using a small amount of the reactive gas. As the result, even if the introduction rate of the reactive gas is reduced, a particle that is not a complete compound and ejected from the target, and a thin film-shaped product that is not a complete compound and formed by the accumulation of such particle on the substrate can be brought into a sufficient reaction, so that a thin film of a metal compound can be formed in the metal or transitional region mode.

Further, the thin film-shaped product that is not a complete compound and formed by the accumulation of the particle on the substrate is converted to a complete metal compound by contacting with the active species of the reactive gas generated by the active species source arranged to produce mutual electromagnetic and pressure interactions with the target, thus it becomes possible to arrange the target and the active species source to produce mutual electromagnetic and pressure interactions, and obviate the need for separating spatially as well as in a pressure-wise manner between the target and the active species source, thereby enabling to form a film using a thin film formation apparatus having a simple constitution.

Additionally, the method of forming a thin film of the present invention may include a film formation repetitive step, in which the sputtering step and the composition conversion step are repeated in parallel a plurality of times after the composition conversion step.

In such configuration, it is possible to deposit a metal compound to form a film by sputtering performed in the metal or transitional region mode instead of the reactive mode, and produce a thin film of the metal compound having a desired film thickness.

Before the sputtering step, the method may also include a step of introducing the substrate into an in-line type thin film formation apparatus having a plurality of film-forming stations each including the target and the active species source disposed on at least one of the upstream and downstream sides of the target in the substrate conveyance direction. Then the method may further include an in-station film formation step, where the sputtering step, the composition conversion step, and the film formation repetitive step are carried out in the film-forming stations while the substrate is conveyed at a constant speed, a conveyance step for conveying the substrate to the film-forming stations located on the downstream side in the substrate conveyance direction, and a multiple-station film formation step, where the in-station film formation step and the conveyance step are repeated. After the in-station film formation step is completed in the film-forming station on the most downstream side in the substrate conveyance direction, a discharge step for discharging the substrate to the atmosphere may be performed.

Having such configuration makes it possible to form a multilayer film composed of a metal compound having a desired number of layers by appropriately selecting the number of the film-forming stations.

### Effect of the Invention

In a conventional reactive sputtering, where a target such as metal is sputtered while a reactive gas is introduced, a metal compound is formed on the surface of the target as the introduction rate of the reactive gas increases, so that film formation is performed in the reactive mode with a low film deposition rate. In contrast, in the thin film formation method of the present invention, a metal compound can be deposited on a film by sputtering in the metal or transitional region mode instead of the reactive mode, thus an optical multilayer film can be formed at a high film deposition rate.

That is, because the active species source is arranged to produce mutual electromagnetic and pressure interactions with the target, this configuration creates plasma interactions between a plasma generated by applying a voltage to the target and a plasma generated by the active species source, and thereby increases the plasma density in the area between the target and the substrate. As the result, the amount of the sputtering gas active species such as Ar⁺ increases in the vicinity of the target and the sputtering efficiency is improved.

Further, because of the improvement of the sputtering efficiency, metal or a conductive metal compound is ejected from the target surface before a metal compound is formed on the target surface. Thus, formation of the metal compound is suppressed on the target surface, and the film deposition rate is prevented from being decreased.

Further, the active species of the reactive gas is generated by the active species source, thus making it possible to achieve a high reaction efficiency using a small amount of the reactive gas. As the result, even if the introduction rate of the reactive gas is reduced, a particle that is not a complete compound and ejected from the target, and a thin film-shaped product that is not a complete compound and formed by the accumulation of such particle on the substrate can be brought into a sufficient reaction. Thus, a thin film of a metal compound can be formed in the metal or transitional region mode.

### BRIEF DESCRIPTION OF THE DRAWINGS

Fig.1 is an explanatory diagram illustrating an in-line type sputtering apparatus according to an embodiment of the present invention;
Fig.2 is an enlarged explanatory diagram illustrating a configuration of a film-forming station of the in-line type sputtering apparatus according to the embodiment of the present invention;
Fig.3 is a schematic explanatory diagram illustrating a radical source according to the embodiment of the present invention;
Fig.4 is a schematic explanatory diagram illustrating the radical source according to the embodiment of the present invention;
Fig.5 is an explanatory diagram illustrating an in-line type sputtering apparatus according to another embodiment of the present invention;
Fig.6 is a graph showing a comparison of reflectance values at the different wavelengths between a multilayer AR film formed in Example 9 and a multilayer AR film in design, where a first layer is Si₃N₄ having the physical film thickness of 123.9 nm, a second layer is SiO₂ having the physical film thickness of 164.3 nm, a third layer is Si₃N₄ having the physical film thickness of 99.5 nm, and a fourth layer is SiO₂ having the physical film thickness of 73.2 nm;
Fig.7 is a graph showing a relation between an oxygen partial pressure and a target voltage measured in the in-line type sputtering apparatus according to the embodiment of the present invention under the conditions where oxygen gas flow rate is increased and decreased; and
Fig.8 is a graph showing a relation between a reactive gas flow rate/total gas flow rate ratio, and a film deposition rate (rate of forming thin film) in a conventional sputtering.

### DETAILED DESCRIPTION OF THE INVENTION

Hereinafter, embodiments of the present invention will be described with reference to the drawings. The members, the arrangements, and the like described below do not limit the invention of the present application, and may be, of course, modified into various forms in accordance with the spirit of the invention.

In the specification, an active species of a reactive gas refers to a highly reactive particle generated as a result of reactions such as ionization, dissociation, adhesion, excitation, and the like caused by high-speed electrons colliding against reactive gas molecules and atoms in plasma, and includes an ion, a radical, an excited species, and the like of a reactive gas.

The radical of a reactive gas includes a reactive gas radical, in which a molecular ion, an atom, and an inner shell electron of the reactive gas are in an excited state and are more active than a reactive gas molecule.

### (Thin film formation apparatus)

A sputtering apparatus 1 as a thin film formation apparatus of the present embodiment is a so-called load locked type and in-line type sputtering apparatus, and is composed of a load lock chamber 11, a film deposition chamber 21, an unloading chamber 31, and a substrate conveyance device not illustrated.

The load lock chamber 11 includes a gate valve 12 for making the load lock chamber 11 open to the atmosphere, a gate valve 13 provided between itself and the film deposition chamber 21, and a rotary pump 14 for evacuating the load lock chamber 11.

The unloading chamber 31 includes a gate valve 32 for making the unloading chamber 31 open to the atmosphere, a gate valve 33 provided between itself and the film deposition chamber 21, and a rotary pump 34 for evacuating the unloading chamber 31.

The substrate conveyance device not illustrated is a known substrate conveyance device used in an in-line type sputtering apparatus, and includes a substrate holder not illustrated for holding a substrate 43, and a substrate conveyance mechanism not illustrated. By the substrate conveyance device, the substrate 43 is introduced from the atmosphere to the load lock chamber 11, the film deposition chamber 21, and the unloading chamber 31, and then conveyed to the atmosphere.

The substrate 43 is fixed to the substrate holder not illustrated.

The substrate 43 is a so-called large-sized substrate, such as optical members with a large area, large window glasses for building, large FPDs (flat panel displays), and the like.

A single substrate 43 may be fixed to the substrate holder not illustrated, or a plurality of substrates, for example, four substrates each having the size of one quarter of the substrate 43, i.e. the single substrate 43 being horizontally and vertically divided into two equal parts, may be fixed to the substrate holder not illustrated.

The film deposition chamber 21 includes a plurality of film-forming stations ST (ST1 to STn)(n is a positive integer) which are connected together, and one end of the film deposition chamber 21 is connected to the load lock chamber 11 via the gate valve 13, while the other end is connected to the unloading chamber 31 via the gate valve 33. The bottom part of the film deposition chamber 21 is connected to a pipe 95b for exhaust, and the pipe 95b is connected to a vacuum pump 95 for evacuating the interior of the film deposition chamber 21. A configuration is made to adjust the degree of vacuum inside of the film deposition chamber 21 by the vacuum pump 95 and a controller not illustrated.

The film deposition chamber 21 is a hollow casing body extending in the conveyance direction of the substrate 43, and includes the plurality of film-forming stations ST (ST1 to STn) that are connected together between a space part 22 for loading located at the load lock chamber 11 side, and a space part 23 for unloading located at the unloading chamber 31 side.

The film-forming stations ST are formed as a hollow casing body with both ends open to make a connection to the precedent and following film-forming stations ST, or the space part 22 for loading and the space part 23 for unloading. All film-forming stations ST1 to STn include in their inside a target mechanism 61, a radical source 80 as an energy source for an active species source, and a pipe 75 for introducing an reactive gas from a gas cylinder 76 as a gas source.

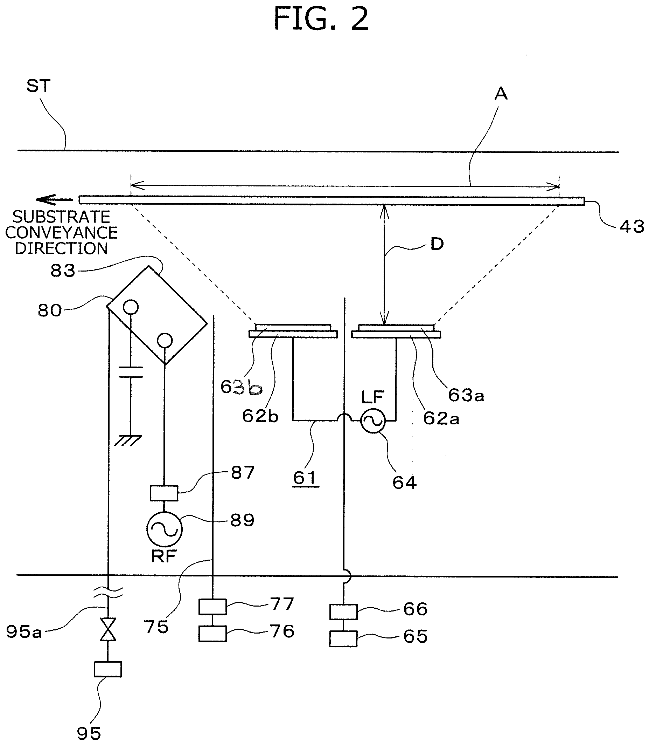

The target mechanism 61 is, as shown in Fig.2, connected to magnetron sputter electrodes 62a and b arranged to be opposed to the substrate 43, and targets 63a and b held by the magnetron sputter electrodes 62a and b via a transformer not illustrated, and includes an AC power supply 64 capable of applying an alternating electric field, a gas cylinder 65 for storing a sputtering gas composed of an inert gas such as an argon gas, which serves as an operating gas in sputtering, and a mass flow controller 66 for introducing the sputtering gas stored in the gas cylinder 65.

The magnetron sputter electrodes 62a and b are arranged to be parallel with the substrate 43 held by the substrate holder not illustrated.

The targets 63a and b are disposed in such a way that the sputtering surfaces where erosion occurs are arranged to be parallel with the substrate 43. Erosion in this description refers to a phenomenon where target-constituting elements are sprung out by a sputtering phenomenon leading to a consumption of the target.

The targets 63a and b are metal targets, conductive metal compound targets, or composite targets, which are known and generally used in sputtering. Examples of such targets include silicon (Si), niobium (Nb), aluminum (Al), titanium (Ti), zirconium (Zr), tin (Sn), chromium (Cr), tantalum (Ta), tellurium (Te), iron (Fe), magnesium (Mg), hafnium (Hf), nickel-chromium (Ni-Cr), indium-tin (In-Sn), and the like.

The size of the targets 63a and b of the present embodiment is 5 x 27 inches, and a distance D between the targets 63a and b, and the substrate 43 is 70-400 mm.

By sputtering the targets 63a and b, a metal compound is deposited to form a film in a film-forming effective area A shown in Fig.2.

An AC power supply 64 of the present embodiment is constituted of an LF power supply, however, the present invention is not limited thereto, and the AC power supply 64 may be constituted of an RF power supply, a dual frequency RF power supply, and the like.

In the present embodiment, the degree of vacuum in the film-forming stations ST is adjusted by the vacuum pump 95, and then an inert gas such as an argon gas is introduced from the gas cylinder 65 by the mass flow controller 66 to adjust a vacuum gas atmosphere of the film-forming stations ST in order to perform a dual magnetron sputtering.

The dual magnetron sputtering uses a pair of magnetron sputter electrodes 62a and b, and a pair of targets 63a and b, both of which are electrically insulated from ground potential. Thus, although it is not illustrated, the magnetron sputter electrodes 62a and b, and the targets 63a and b are attached via an insulation material to the sputtering apparatus 1 body that is grounded. Further, the magnetron sputter electrodes 62a and b, and the targets 63a and b are also mutually electrically disconnected.

In this configuration, when an operating gas such as an argon gas is introduced in the vicinity of the targets 63a and b to adjust a sputtering atmosphere, and a voltage is applied to the magnetron sputter electrodes 62a and b from the AC power supply 64 via the transformer not illustrated, the targets 63a and b are constantly applied with an alternating electric field. That is, at a given time point, the target 63a becomes a cathode (minus electrode), and the target 63b always becomes an anode (plus electrode). At the next time point when the direction of the AC current is reversed, the target 63b becomes a cathode, and the target 63a becomes an anode. The paired targets 63a and b alternately become an anode and a cathode in this manner to generate plasma, as the result, the target on a cathode is sputtered to form an ultrathin film of metal on a substrate.

In the process of sputtering, an incomplete reaction product of metal with low or no conductivity may adhere to an anode. However, when the anode is converted to a cathode by the alternating electric field, the incomplete reaction product of metal is sputtered, and the surface of the target becomes clean again. By repeating this process, a potential state of an anode is stably maintained at all times, thereby preventing variations in plasma potential, which is usually substantially equal to an anode potential. Thus, a metal particle can be stably dispersed to a substrate 43 from targets 63a and b.

The targets 63a and b may contain the same metal, or different metal. When the targets each containing the same metal are used, a thin film containing one metal is formed, while when the targets each containing different metal are used, a thin film of an alloy product is formed.

The frequency of an AC voltage applying to the targets 63a and b is preferably 10-120 KHz.

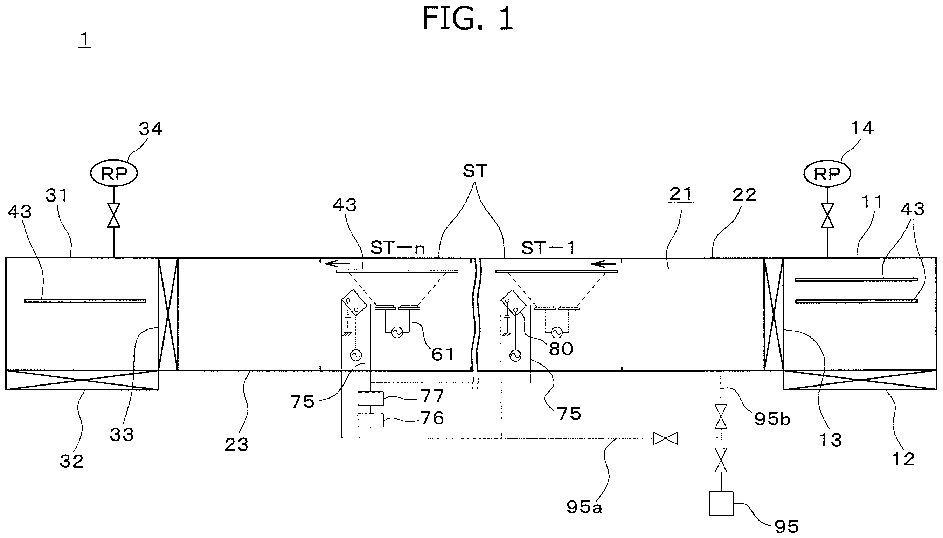

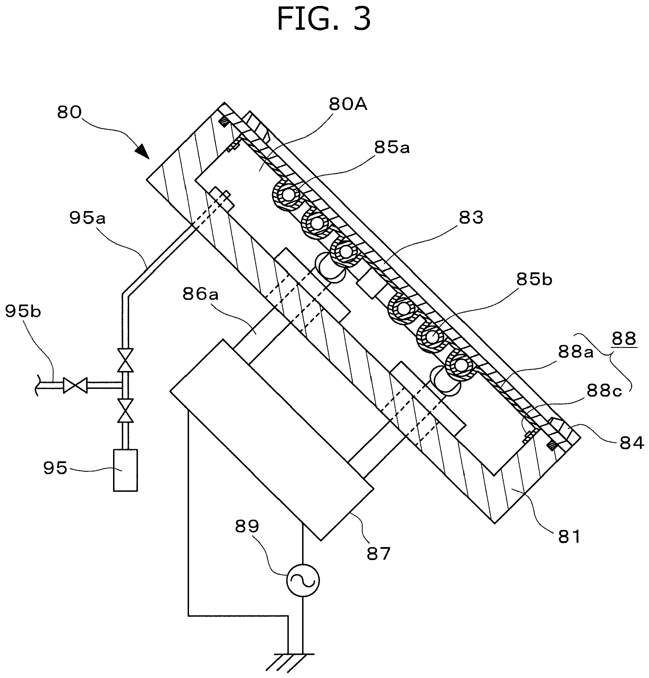

The radical source 80 consists of an inductive coupling type plasma generator section having a high frequency antenna, and as shown in Fig.1 and Fig.2, each radical source 80 is provided on the downstream side of the target mechanism 61. As shown in Fig.3, the radical source 80 includes a case body 81, a dielectric plate 83, a fixed frame 84, antennas 85a and b, a fixture 88, a pipe 95a, and a vacuum pump 95.

As shown in Fig.3, the case body 81 is an approximately rectangular container made of stainless steel, having an opening portion in one face. The dielectric plate 83 is fixed to the container to close the opening, thereby constituting a dielectric window. The internal space of the case body 81 closed by the dielectric window constitutes an antenna storage chamber 80A.

The antenna storage chamber 80A is partitioned from the film-forming stations ST by the dielectric plate 83 to form a space independently from the film-forming stations ST. The dielectric plate 83 is a known dielectric having a plate-like shape, and is made of quartz in the present embodiment.

The fixed frame 84 is a rectangular frame. The fixed frame 84 and the case body 81 are connected by bolts not illustrated in such a way that the dielectric plate 83 is held and fixed by the fixed frame 84 and the case body 81.

The antennas 85a and b are disposed in the antenna storage chamber 80A.

The antennas 85a and b consist of spiral coil electrodes in which the surface of round tubes made of copper is coated with silver, and are disposed in the antenna storage chamber 80A in such a way that the spiral face of the electrodes is arranged in parallel with the bottom surface of the case body 81 and the dielectric plate 83.

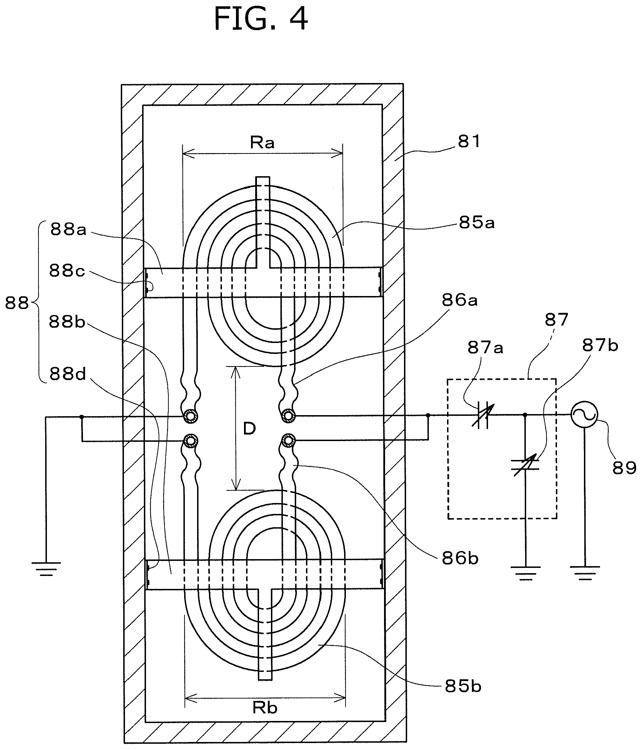

The antennas 85a and b are connected in parallel with a high frequency power source 89. Further, as shown in Fig.4, the antennas 85a and b are connected via conductive wires 86a and b, respectively to a matching box 87 having variable capacitors 87a and b, and further connected to the high frequency power source 89.

The fixture 88 is composed of fixing plates 88a and b, which are plates having grooves to which the antennas 85a and b can be fitted, and fixing bolts 88c and d.

The antennas 85a and b are respectively fitted into the fixing plates 88a and b, and fixed to the case body 81 by the fixing bolts 88c and d. A plurality of bolt holes are formed to the case body 81 in the up to down direction, and the fixing plates 88a and b are fixed to the case body 81 using some of the bolt holes.

In order to insulate the fixing plates 88a and b from the antennas 85a and b, an insulating material is installed at least in contact faces between the antennas 85a and b, and the fixing plates 88a and b.

As shown in Fig.3, the bottom surface of the case body 81 is provided with the pipe 95a for exhaust, and connected to the vacuum pump 95 via valves. This configuration makes it possible to evacuate the inside of the antenna storage chamber 80A through the operation of the valves by using the vacuum pump 95 for evacuating the film-forming stations ST. It should be noted that Fig.1 only shows a portion of the pipe 95 connecting to some radical sources 80.

In the present embodiment, as shown in Fig.3 and Fig.4, an inductive coupling type plasma source having spiral antennas in a flat spiral shape is used, however, different types of inductive coupling type plasma source may also be used. Examples of the different types include the one in which high-frequency current is applied to a coil having a cylindrical helical antenna wound on a glass tube in a spiral manner, and the one in which an antenna is inserted to the inside of plasma.

Further, other plasma sources in which plasma is generated by inductive coupling and surface wave through a dielectric window may be used, and examples of such plasma sources include electron cyclotron resonance plasma (ECP) source, helicon wave excited plasma (HWP) source, microwave-excited surface wave plasma (SWP) source, and the like.

Instead of using the inductive-coupling type plasma source, a capacitance-coupling type plasma source may also be used, in which a plate-shaped electrode is disposed within the antenna storage chamber 80A and applied with high frequency power of 100 KHz-50 MHz to generate plasma.

Further, a plasma source generating plasma in which inductive-coupling type plasma and capacitance-coupling type plasma are mixed may also be used.

In the film-forming stations ST, as shown in Fig.2, a pipe 75 is provided between the radical source 80 and the substrate 43, and is connected to a gas cylinder 76 for supplying an reactive gas via a mass flow controller 77. This configuration makes it possible to supply the reactive gas to an area between the radical source 80 and the substrate 43.

In the present embodiment, oxygen gases, such as oxygen (O₂), ozone (O₃), and dinitrogen oxide (N₂O), nitrogen gases, such as nitrogen (N₂), carbon gases, such as methane (CH₄), fluorine gases, such as fluorine (F₂) and carbon tetrafluoride (CF₄), and the like may be used as a reactive gas.

In the present embodiment, the mass flow controller 66 for introducing the sputtering gas, and the mass flow controller 77 for introducing the reactive gas are independently installed. Having such configuration makes it possible to perform a feedback control of the film deposition rate by independently controlling a power and a gas flow rate of the sputtering, and a power and a gas flow rate of the active species source while monitoring a film deposition rate and the like.

As shown in Fig.2, the radical source 80 is inclined toward the substrate 43 in such a way that the surface plane of the dielectric plate 83, i.e. the surface plane of the dielectric window formed by the dielectric plate 83 faces the center area of the substrate 43. The angle between the surface plane of the dielectric plate 83 and the substrate 43 is in the range of 0°≤ and <90°. In another words, the dielectric plate 83 is arranged in parallel with the targets 63a and b, or in such a way as inclining towards the substrate 43 held by the substrate holder not illustrated with an angle of 0°≤ and <90°, so that the outside of the film-forming stations ST becomes closer to the substrate 43. The preferable angle between the surface plane of the dielectric plate 83 and the substrate 43 is 0°-60° for obtaining the highest film deposition rate.

Further, each film-forming station ST includes an optical film-forming rate controller not illustrated, and thus can control a film-forming rate to adjust the thicknesses of a film by modifying sputtering conditions in each film-forming station ST using the optical film-forming rate controller.

The optical film-forming rate controller not illustrated includes an optical film thickness meter not illustrated for measuring the thin film thickness formed on the substrate 43, and a controller unit not illustrated for adjusting gas flow rates by controlling mass flow controllers 66 and 67 on the basis of film thickness measurement results obtained by the optical film thickness meter.

As the optical film thickness meter, a transmission type optical film thickness meter that measures light transmitting through an optical thin film upon being emitted from a projector is used. However, a reflection type optical film thickness meter may also be used, in which the film thickness is measured by using an interference phenomenon caused by a phase difference occurring between the light reflected on the surface of an optical thin film, and the light reflected on an interface between a substrate and an optical film due to their having different light paths.

During sputtering, the optical film thickness meter not illustrated monitors the thickness of a thin film being formed on the substrate 43 in each film-forming station ST, and if the optical film thickness meter detects a decrease in a film deposition rate, then it performs a control to return the film deposition rate to the original level by increasing current capacity of the AC power supply 64 and the high frequency power source 89.

The radical source 80 of the present embodiment induces a reactive gas stored in the reactive gas cylinder 76 to the film-forming stations ST via the mass flow controller 77 while keeping the pressure in the antenna storage chamber 80A lower than that in the film-forming stations ST. The antennas 85a and b are supplied with a voltage of 13.56 MHz from the high frequency power source 89 in order to flow a high-frequency current. In this manner, the generation of plasma is suppressed in the antenna storage chamber 80A, and the antennas 85a and b supplied with the voltage from the high frequency power source 89 generate an induced electric field within the film-forming stations ST, thereby generating plasma of the reactive gas.

In each film-forming station ST, the target mechanism 61 is provided in the center of the film-forming stations ST in the substrate conveyance direction, and a single radial source 80 is provided on the downstream side of the target mechanism 61 in the substrate conveyance direction.

The number of the film-forming stations ST (ST1 to STn) constituting the film deposition chamber 21 is determined to be greater than or equal to the number of layers in a multilayer film to be formed. If the number of the film-forming stations ST to be installed is equal to the number of layers in a multilayer film to be formed, each film-forming station ST forms one layer of the multilayer film. If the number of the film-forming stations ST to be installed is greater than the number of layers in a multilayer film to be formed, at least one layer of the multilayer film is formed by a plurality of the film-forming stations ST.

The space part 22 for loading and the space part 23 for unloading have the same configuration as the film-forming stations ST except that the target mechanism 61 or the radical source 80 is not provided within the space part 22 or 23.

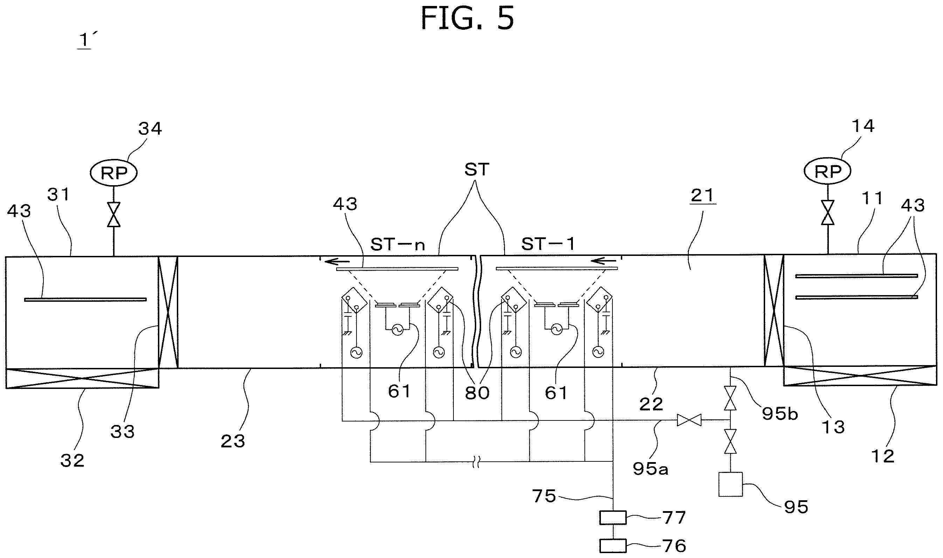

In the present embodiment, only one radical source 80 is disposed on the upstream side of the target mechanism 61, however, like a sputtering apparatus 1' in Fig.5, a pair of radical sources 80 may be disposed on both the upstream and downstream sides of the target mechanism 61 to interpose the target mechanism 61. Other configuration of the sputtering apparatus 1' is the same as in the sputtering apparatus 1, thus the description thereof will be omitted.

A single radical source may be also disposed on the downstream side of the target mechanism 61.

### (Method of foaming thin film)

A method of foaming a thin film using a sputtering apparatus 1 of the present embodiment will be described below.

First, the inside of the film deposition chamber 21 is evacuated. Then, a prescribed number of substrates 43 with a large size are prepared by mounting them on the substrate folders not illustrated. The prescribed number of substrates 43 are introduced into the load lock chamber 11 of the sputtering apparatus 1 by opening the gate valve 12, and then the gate valve 12 is closed. The load lock chamber 11 in an atmospheric state is evacuated until the degree of vacuum becomes equivalent to that in the film deposition chamber 21.

Next, the target mechanism 61 and the radical source 80 in each film-forming station ST are put in operation to start the sputtering, while a first substrate 43 is introduced into the space part 22 for loading in the film deposition chamber 21 by opening the gate valve 13.

While the substrates 43 are moved at constant speed toward the film-forming station STn by a substrate conveyance mechanism not illustrated, film deposition is sequentially performed in the film-forming stations in the order of ST1 to STn.

In each film-forming station ST1 to STn, a thin film of a metal compound is formed as follows.

When the substrate 43 is conveyed by the substrate conveyance mechanism and introduced in the first film-forming station ST1, the substrate 43 is gradually introduced in a film-forming effective area A shown in Fig.2 from the upstream side in the substrate conveyance direction.

When the substrate 43 enters the film-forming effective area A, first in the sputtering step, metal particles are beaten out from the targets 63a and b by sputtering and dispersed toward the substrate 43 in an area surrounded by the film-forming effective area A, and the targets 63a and b.

Next, some of dispersed metal particles are converted to incomplete reaction products of metal by radicals of a reactive gas generated in the radical source 80 while the dispersed metal particles travel from the targets 63a and b to the substrate 43. These metal particles and incomplete reaction products of metal are equivalent to a particle that is not a complete compound falling under the embodiments.

Then, the metal particles and the incomplete reaction products of metal are deposited on the substrate 43 to form a thin film-shaped product that is not a complete compound.

In the following composition conversion step, the thin film-shaped product that is not a complete compound on the substrate 43 is converted to a complete compound of metal by radicals of a reactive gas generated in the radical source 80.

While the substrate 43 is passing through the film-forming effective area A, the sputtering step and the composition conversion step are executed repeatedly in parallel, so that a thin film of a metal compound is formed on the substrate 43 by the time the substrate 43 is discharged from the film-forming effective area A.

In the second and subsequent film-forming stations ST2 to STn, the same steps are performed as in the film-forming station ST1, and a thin film composed of a complete compound of metal is formed in each station.

If a combination of metal in the targets 63a and b is the same between adjacent film-forming stations STi and STi+m (i and m each denotes a positive integer), the adjacent film-forming stations STi and STi+m form a thin film having an identical layer. That is, one layer of a thin film is formed by a plurality of film-forming stations STi and STi+m.

On the other hand, if a combination of metal in the targets 63a and b is different between adjacent film-forming stations STi and STi+m (i and m each denotes a positive integer), the adjacent film-forming stations STi and STi+m form a thin film having multiple layers.

During the sputtering by the targets 63a and b. and the radical formation of the reactive gas by the radical source 80, the film deposition rate is controlled by an optical film deposition rate control mechanism not illustrated. The film deposition rate control mechanism adjusts the gas flow rates by regulating the mass flow controllers 66 and 77 based on the data of the amount of the metal, the gases, and the metal compounds detected by an optical fiber not illustrated, thereby controlling the film deposition rates to a desired value. As such, the film thickness is controlled in the film-forming stations ST.

After the film formation and reaction are completed in the film-forming stations ST, the substrate 43 is introduced into the space part 23 for unloading. The space part 23 for unloading is evacuated in advance until the degree of vacuum becomes equivalent to that in the film deposition chamber 21. The substrate 43 is introduced into the unloading chamber 31 by opening the gate valve 33 and stored in the unloading chamber 31 after closing the gate valve 33.

Next, an upcoming substrate 43 stored in the load lock chamber 11 is introduced into the film deposition chamber 21, and after completing the same film formation and reaction, introduced and stored in the unloading chamber 31 in the same manner. After completing the same treatments on all substrates 43 stored in the load lock chamber 11, the unloading chamber 31 is switched to an atmospheric state and then all the substrates 43 are taken out in the atmosphere by opening the gate valve 32 to finish the film formation.

By performing the above-described method, a multilayer film of a metal compound having the number of layers according to the number of the film-forming stations ST and the kinds of metal and reactive gases is formed.

If different kinds of metal and reactive gases are used in all film-forming stations ST that are adjacent to each other, a multilayer film has the number of layers equivalent to the number of the film-forming stations ST. If the same kinds of metal and reactive gases are used in the film-forming stations ST that are adjacent to each other, these adjacent film-forming stations ST all together form one layer of a film.

### Examples

The present invention is explained below in greater detail through Examples.

### (Test Example 1)

In the present Test Example, a radical source 80 was disposed in such a way that the surface plane of a dielectric plate 83 was in parallel with a substrate 43 as well as targets 63a and b. In Examples 1 to 4, a distance D between the substrate 43, and the targets 63a and b in a film-forming statins ST was respectively set to 40 mm, 70 mm, 200 mm, and 400 mm for forming a film. Then, film deposition rates and obtained films were compared among those Examples.

In the present Test example, a sputtering apparatus 1 having a single film-forming station ST was used to form a single layer film of silicon oxide on a large-sized glass substrate having a size of 600 cm x 400 cm by the method of forming a thin film according to the embodiment described above.

In the film-forming station ST1, a silicon target was used as the targets 63a and b, and an argon gas was supplied at 800 sccm from a gas cylinder 65 as a sputtering gas. As a reactive gas, oxygen (O₂) gas was introduced at 80 sccm and converted to a radical by a radical source 80.

Other specific conditions and results are shown in Table 1.

**[Table 1]**

| | Distance D (mm) | Angle of radical source (deg.) | Target LF Power (kW) | Radical source RF Power (kW) | Film deposition rate (nm·m/min) | Index of refraction @550 nm | Absorption coefficient |
|---|---|---|---|---|---|---|---|
| Example 1 | 40 | 0 | 7.0 | 4.5 | 85.8 | 1.48 | 5.8 x 10⁻³ |
| Example 2 | 70 | 0 | 7.0 | 4.5 | 70.9 | 1.48 | 4.6 x 10⁻⁴ |
| Example 3 | 200 | 0 | 7.0 | 3 | 63.4 | 1.48 | 1.8 x 10⁻⁴ |
| Example 4 | 400 | 0 | 7.0 | 2.5 | 26.1 | 1.47 | 1.7 x 10⁻⁴ |

Based on the results in Table 1, it was found that when the distance D was 40 mm, absorption coefficient of a formed film ended up being high over 10⁻³. This may be because if the distance D is too short, the film deposition rate becomes too high for a reaction to keep up and the absorption occurs.

As optical thin film requires the absorption coefficient in a range of 10⁻⁴ to obtain a sufficient transmittance, it was found that the distance D needed to be longer than 40 mm.

### (Test Example 2)

In the present Test Example, the distance D between the substrate 43, and the targets 63a and b in the film-forming statins ST was set to 200 mm, and the radical source 80 was disposed in such a way that the surface plane of the dielectric plate 83 was inclined toward the targets 63a and b side with an angle of 0°, 30°, and 60° to the substrate 43 to form a film in Examples 3, 5, and 6, respectively. Then, film deposition rates and obtained films were compared among those Examples.

Specific conditions and results are shown in Table 2. Other conditions of the present Test Example were the same as those in the Test Example 1.

**[Table 2]**

| | Distance D (mm) | Angle of radical source (deg.) | Target LF Power (kW) | Radical source RF Power (kW) | Film deposition rate (nm*m/min) | Index of refraction @550 nm | Absorption coefficient |
|---|---|---|---|---|---|---|---|
| Example 3 | 200 | 0 | 7.0 | 3 | 63.4 | 1.48 | 1.8 x 10⁻⁴ |
| Example 5 | 200 | 30 | 8.0 | 3 | 70.9 | 1.48 | 1.7 x 10⁻⁴ |
| Example 6 | 200 | 60 | 8.0 | 3 | 67.1 | 1.48 | 3.0 x 10⁻⁴ |

The results in Table 2 showed that the film deposition rate was higher in the case where the surface plane of the dielectric plate 83 was inclined with an angle of 30° and 60° to the substrate 43 than the case where the surface plane was not inclined. Therefore, it was found that if the radical source 80 was inclined toward the targets 63a and b side, the reactivity came to improve while the absorption coefficient was kept to an appropriate level, thus making it possible to increase a target power and further improve the film deposition rate.

### (Test Example 3)

In the present Test Example, a film was formed in a sputtering apparatus 1 having a single film-forming station ST. Film deposition rates and obtained films were compared between the case where one radical source 80 was provided and the case where a pair of radical sources 80 were provided on both the upstream and downstream sides of the targets 63a and b to interpose them.

Specific conditions and results are shown in Table 3. Other conditions of the present Test Example were the same as those in the Test Example 1.

**[Table 3]**

| | Distance D (mm) | Angle of radical source (deg.) | Target LF Power (kW) | Radical source RF Power (kW) | Film deposition rate (nm*m/min) | Index of refraction @550 nm | Absorption coefficient |
|---|---|---|---|---|---|---|---|
| Example 5 | 200 | 30 | 8.0 | 3 | 70.9 | 1.48 | 1.7 x 10⁻⁴ |
| Example 7 | 200 | 30 | 9.0 | 3 x 2 | 78.3 | 1.48 | 1.7 x 10⁻⁴ |

The results in Table 3 showed that the film deposition rate was higher by around 10 percent in the case where the pair of radical sources 80 were provided than the case where one radical source 80 was provided, while the absorption coefficient values were substantially the same between them. Therefore it was found that if the pair of radical sources 80 were provided, the reactivity came to improve while the absorption coefficient was kept to an appropriate level, thus making it possible to increase a target power and further improve the film deposition rate.

### (Test Example 4)

In the present Test Example, a multilayer AR film was formed using the sputtering apparatus 1 according to the embodiment described above to compare film-forming conditions and obtained films between Example 8, where each layer is formed by a single station ST and Example 9, where each layer is formed by a plurality of stations ST.

In Examples 8 and 9, the multilayer AR film was designed as follows: a first layer is Si₃N₄ having physical film thickness of 123.9 nm, a second layer is SiO₂ having physical film thickness of 164.3 nm, a third layer is Si₃N₄ having physical film thickness of 99.5 nm, and a fourth layer is SiO₂ having physical film thickness of 73.2 nm.

In Example 8, a sputtering apparatus 1 having four film-forming stations ST was used, and in each film-forming station ST1 to ST4, a silicon target was used as targets 63a and b, and an argon gas was supplied at 800 sccm from a gas cylinder 65 as a sputtering gas. Further, as a reactive gas, nitrogen gas (N₂) at 140 sccm was introduced in the film-forming stations ST1 and ST3, and oxygen (O₂) gas at 60 sccm was introduced in the film-forming stations ST2 and ST 4, and these gases were converted to radicals by a radical source 80. The film-forming stations ST1-4 respectively formed Si₃N₄, SiO₂, Si₃N₄, and SiO₂ films.

Additionally, a substrate conveying speed was set to 4.4 mm/s, the distance D to 200 mm, and the angle between the dielectric plate 83 and the substrate 43 to 30°.

Other specific conditions and results of Example 8 are shown in Table 4.

**[Table 4]**

| | Film composition | Physical film thickness (nm) | Target LF Power (kW) | Radical source RF Power (kW) | Radical source gas species | Radical source gas flow rate (sccm) |
|---|---|---|---|---|---|---|
| ST1 | Si₃N₄ | 123.9 | 13.0 | 3 | N₂ | 140 |
| ST2 | SiO₂ | 164.3 | 5.6 | 3 | O₂ | 60 |
| ST3 | Si₃N₄ | 99.5 | 10.4 | 3 | N₂ | 140 |
| ST4 | SiO₂ | 73.2 | 2.5 | 3 | O₂ | 40 |

In Example 9, a sputtering apparatus 1 having seven film-forming stations ST was used. In the film-forming stations ST1-6, each pair of adjacent film-forming stations ST formed a film having the same composition, so that all together three layers, Si₃N₄, SiO₂, and Si₃N₄, were formed, while in the film-forming station ST7, a SiO₂ film was formed on the top of the stack by the single film-forming station ST. Film thickness of each four layer in an obtained film was designed to be equal to the corresponding each four layer in Example 8.

Additionally, the substrate conveying speed was set to 8.7 mm/s, the distance D to 200 mm, and the angle between the dielectric plate 83 and the substrate 43 to 30°.

Other specific conditions and results of Example 9 are shown in Table 5.

**[Table 5]**

| | Film composition | Physical film thickness (nm) | Target LF Power (kW) | Radical source RF Power (kW) | Radical source gas species | Radical source gas flow rate (sccm) |
|---|---|---|---|---|---|---|
| ST1 | Si₃N₄ | 62.0 | 13.0 | 3 | N₂ | 140 |
| ST2 | Si₃N₄ | 62.0 | 13.0 | 3 | N₂ | 140 |
| ST3 | SiO₂ | 82.2 | 5.6 | 3 | O₂ | 60 |
| ST4 | SiO₂ | 82.2 | 5.6 | 3 | O₂ | 60 |
| ST5 | Si₃N₄ | 49.8 | 10.4 | 3 | N₂ | 120 |
| ST6 | Si₃N₄ | 49.8 | 10.4 | 3 | N₂ | 120 |
| ST7 | SiO₂ | 73.2 | 5.0 | 3 | O₂ | 60 |

In Test Example 4, it was found that the film thickness of each layer is approximately the same between Example 9, where the plurality of film-forming stations ST were used to form one layer of the film, and Example 8, where the single film-forming station ST was used to form one layer of the film. Further, the substrate conveying speed in Example 9 was approximately twice as fast as that in Example 8, however, since the first three layers were formed by two film-forming stations ST in Example 9, the total time required for forming a film per one substrate 43 was the same between Example 9 and Example 8.

However, the substrate conveying speed in Example 9 is faster than that in Example 8, and there are more film-forming stations ST in the sputtering apparatus 1 in Example 9, thus when the substrates 43 are continuously conveyed into the sputtering apparatus 1 in an in-line manner, the maximum number of the substrates 43 residing in the sputtering apparatus 1 becomes higher and the productivity is improved.

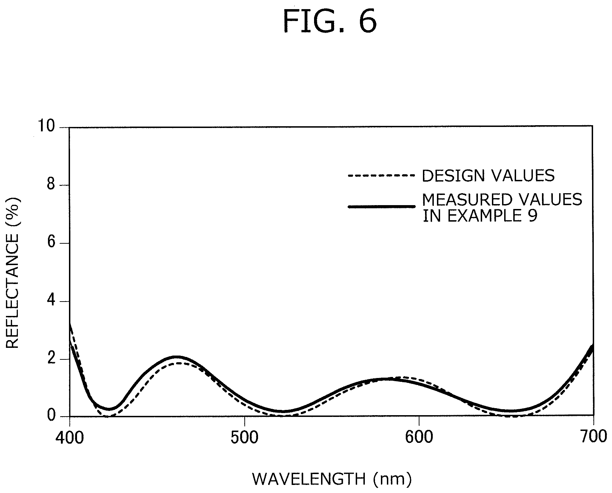

Fig.6 is a graph showing a comparison of reflectance values at the different wavelengths between a multilayer AR film formed in Example 9 and a multilayer AR film in design, where a first layer is Si₃N₄ having the physical film thickness of 123.9 nm, a second layer is SiO₂ having the physical film thickness of 164.3 nm, a third layer is Si₃N₄ having the physical film thickness of 99.5 nm, and a fourth layer is SiO₂ having the physical film thickness of 73.2 nm.

As shown in Fig.6, it was found that the multilayer AR film formed in Example 9 had optical properties close to those in a film design.

### (Test Example 5)

In the present Test Example, the conditions used were the same as those in Test Example 3 except for an oxygen gas flow rate. A target voltage was measured when the oxygen gas flow rate was at 0, 60, 70, 80, 90, 110, 120, 130, 150, and 200 sccm in a situation where the oxygen gas flow rate was increased from 0 sccm to 200 sccm, and a situation where the oxygen gas flow rate was decreased from 200 sccm to 0 sccm to confirm if the target voltage exhibited variable paths over oxygen partial pressures in the above situations, i.e. if so-called a hysteresis phenomenon occurs.

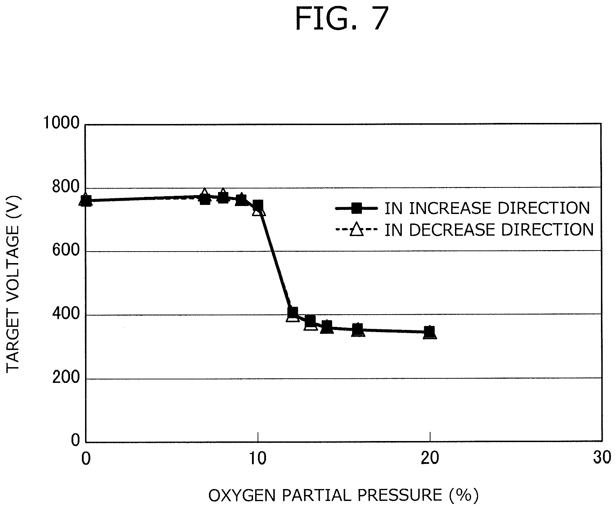

Table 6 shows data on the oxygen gas flow rate, the oxygen partial pressure, and the target voltage on oxygen increase and decrease, while Fig.7 shows a graph depicting a relation between the oxygen partial pressure and the target voltage on oxygen increase and decrease.

**[Table 6]**

| O₂ gas flow rate (sccm) | O₂ gas partial pressure (%) | Target voltage on oxygen increase (V) | Target voltage on oxygen decrease (V) |
|---|---|---|---|
| 0 | 0.0 | 762 | 767 |
| 60 | 7.0 | 767 | 773 |
| 70 | 8.0 | 772 | 777 |
| 80 | 9.1 | 767 | 770 |
| 90 | 10.1 | 750 | 735 |
| 110 | 12.1 | 411 | 404 |
| 120 | 13.0 | 386 | 378 |
| 130 | 14.0 | 369 | 366 |
| 150 | 15.8 | 357 | 356 |
| 200 | 20.0 | 349 | 349 |

Fig.7 showed that the target voltage exhibited substantially the same variable paths over the oxygen partial pressures whether the oxygen flow rate is increased or decreased, and it was found that the hysteresis phenomenon seen during a reactive sputtering didn't occur.

Therefore, it was found that unlike the reactive sputtering, it was easy to control the film deposition rate by adjusting the oxygen flow rate in sputtering using the sputtering apparatus 1 of the present Example by the method according to the embodiment described above.

### Reference Numerals

- A: film-forming effective area A
- D: distance
- ST, ST1-n: film-forming station
- 1,1': sputtering apparatus
- 11: load lock chamber
- 12, 13, 32, 33: gate valve
- 14, 34: rotary pump
- 21: film deposition chamber
- 22: space part for loading
- 23: space part for unloading
- 31: unloading chamber
- 43: substrate
- 61: target mechanism
- 62a, 62b: magnetron sputter electrode
- 63a, 63b: target
- 64 AC: power supply
- 65, 76: gas cylinder
- 66, 77: mass flow controller
- 75, 95a,: 95b pipe
- 80: radical source
- 80A: antenna storage chamber
- 81: case body
- 83: dielectric plate
- 84: fixed frame
- 85a, 85b: antenna
- 86a, 86b: conductive wire
- 87: matching box
- 87a, 87b: variable capacitor
- 88: fixture
- 88a, 88b: fixing plate
- 88c, 88d: fixing bolt
- 89: high frequency power source
- 95: vacuum pump

## Claims

1. A thin film formation apparatus for forming a thin film of a metal compound on a substrate (43) in a vacuum chamber (21) by sputtering, the apparatus comprising: the vacuum chamber (21);
a target (63a, 63b), provided in the vacuum chamber (21), composed of metal or a conductive metal compound, and
an active species source, provided in the vacuum chamber (21), for generating an active species of a reactive gas that is arranged to produce mutual electromagnetic and pressure interactions with the target (63a, 63b), wherein:
the active species source comprises
a gas source (76, 77) for supplying the reactive gas, and
an energy source (80) for supplying energy into the vacuum chamber (21) to excite the reactive gas to a plasma state;
the target (63a, 63b) and the active species source are arranged to be opposed to the substrate (43);
the energy source (80) comprises, between itself and the vacuum chamber (21), a dielectric window for supplying the energy into the vacuum chamber (21), a case body (81) and an antenna (85a, 85b);
the target (63a, 63b) and the active species source are arranged not to be separated spatially or in a pressure-wise manner;
the thin film formation apparatus is an in-line type sputtering apparatus;
a sputtering surface of the target (63a, 63b) where erosion occurs is arranged to be parallel with the substrate (43);
the dielectric window is arranged in such a way as inclining towards the target side at an angle of less than 90° to the substrate (43); and
the antenna (85a, 85b) is disposed in an antenna storage chamber and consists of a spiral coil electrode, and a spiral face of the electrode is arranged in parallel with the dielectric window and the bottom surface of the case body (81).

2. The thin film formation apparatus according to claim 1, wherein:
a substrate conveyance section for conveying the substrate (43) is provided within the vacuum chamber; and
the active species source is provided on at least one of upstream and downstream sides of the target (63a, 63b) in a substrate conveyance direction.

3. The thin film formation apparatus according to claim 1 or 2, wherein the energy source (80) is a plasma source for generating plasma by inductive coupling and surface wave through the dielectric window.

4. The thin film formation apparatus according to any one of claims 1 to 3, wherein the active species source is an inductive coupling type plasma (ICP) radical source.

5. The thin film formation apparatus according to claim 2, further comprising an in-line type sputtering apparatus having a plurality of film-forming stations each comprising the target (63a, 63b) and the active species source disposed on at least one of the upstream and downstream sides of the target (63a, 63b) in the substrate conveyance direction.

6. The thin film formation apparatus according to claim 5,
wherein the film-forming stations each comprises:
a detection unit for optically detecting a film deposition rate; and
a control unit for controlling the film deposition rate in each film-forming station accordingly by receiving a signal from the corresponding film deposition rate detection unit.

7. The thin film formation apparatus according to any one of claims 1 to 6, further comprising:
a sputtering section for sputtering the target (63a, 63b) and by the sputtering, dispersing a particle that is not a complete compound from the target (63a, 63b) to the substrate (43) in the vacuum chamber (21); and
a composition conversion section for converting the particle to a complete metal compound by contacting the particle with an active species of a reactive gas generated by the active species source in the vacuum chamber (21), thereby being capable of forming a thin film composed of the complete metal compound on the substrate (43).

8. The thin film formation apparatus according to claim 1, wherein the target (63a, 63b) and the active species source are disposed side by side in a same space of the vacuum chamber (21) in such a way that a sputtering face of the target (63a, 63b) where erosion occurs and the active species source are arranged to be opposed to the substrate (43), and the active species source are disposed on at least one of upstream and downstream sides of the target in a substrate conveyance direction.

9. The thin film formation apparatus according to claim 1, wherein the dielectric window is arranged in such a way as inclining towards the target side at an angle between 0° to 60° to the substrate (43) which is arranged to be opposed to the energy source (80) in a direction perpendicular to a forwarding direction of the substrate (43).

10. The thin film formation apparatus according to claim 2, wherein:
the active species source is provided on upstream and downstream sides of the target (63a, 63b) in the substrate conveyance direction.

11. The thin film formation apparatus according to claim 1, further comprising:
a mass flow controller (66, 77) for introducing the sputtering gas, and a mass flow controller for introducing the reactive gas, which are independently installed;
a detection unit for optically detecting a film deposition rate; and
a control unit that receives a signal from the detection unit, and independently controls at least a power of the sputtering, the mass flow controller for introducing the sputtering gas, a power of the active species source and the mass flow controller for introducing the reactive gas, thereby controlling the film deposition rate.

12. A method of forming a thin film comprising:
a sputtering step for sputtering a target (63a, 63b) composed of metal or a conductive metal compound, the target (63a, 63b) being arranged to be opposed to a substrate (43), and by the sputtering, dispersing a particle that is not a complete compound from the target to the substrate (43) in a vacuum chamber (21); and
a composition conversion step for converting the particle to a complete metal compound in the vacuum chamber (21) by providing a dielectric window for supplying the energy into the vacuum chamber (21) that is arranged in such a way as inclining towards the target side at an angle of less than 90° to the substrate (43), and by contacting the particle with an active species of a reactive gas generated by an active species source, arranged to be opposed to the substrate (43), for generating the active species of the reactive gas that is arranged to produce mutual electromagnetic and pressure interactions with the target (63a, 63b), thereby forming a thin film composed of the complete metal compound on the substrate (43),
wherein the target (63a, 63b) and the active species source are arranged not to be separated spatially or in a pressure-wise manner,
a thin film formation apparatus used for forming the thin film is an in-line type sputtering apparatus,
a sputtering surface of the target (63a, 63b) where erosion occurs is arranged to be parallel with the substrate (43), and
the active species source further comprises an energy source (80) for supplying energy into the vacuum chamber (21) to excite the reactive gas to a plasma state, the energy source (80) comprises, between itself and the vacuum chamber (21), the dielectric window for supplying the energy into the vacuum chamber (21), a case body (81) and an antenna (85a, 85b), the antenna (85a, 85b) is disposed in an antenna storage chamber and consists of a spiral coil electrode, and a spiral face of the electrode is arranged in parallel with the dielectric window and the bottom surface of the case body (81).

13. The method of forming a thin film according to claim 12, further comprising, after the composition conversion step, a film formation repetitive step where the sputtering step and the composition conversion step are repeated in parallel a plurality of times.

14. The method of forming a thin film according to claim 12 or 13, further comprising:
before the sputtering step, a step of introducing the substrate into the in-line type apparatus having a plurality of film-forming stations each including the target (63a, 63b) and the active species source disposed on at least one of the upstream and downstream sides of the target (63a, 63b) in a substrate conveyance direction;
an in-station film formation step, where the sputtering step, the composition conversion step, and the film formation repetitive step are carried out in the film-forming stations while the substrate (43) is conveyed at a constant speed;
a conveyance step for conveying the substrate (43) to the film-forming stations on the downstream side in the substrate conveyance direction;
a multiple-station film formation step, where the in-station film formation step and the conveyance step are repeated; and
a discharge step for discharging the substrate (43) to the atmosphere after the in-station film formation step is completed in the film-forming station on a most downstream side in the substrate conveyance direction.

## Patentansprüche

1. Dünnfilm-Ausbildungsvorrichtung zum Ausbilden eines Dünnfilms einer Metallverbindung auf einem Substrat (43) in einer Vakuumkammer (21) durch Sputtern, wobei die Vorrichtung umfasst:
die Vakuumkammer (21);
ein Target (63a, 63b), das in der Vakuumkammer (21) vorgesehen ist und aus Metall oder einer leitenden Metallverbindung besteht, und
eine in der Vakuumkammer (21) vorgesehene Quelle für aktive Spezies zur Erzeugung einer aktiven Spezies eines reaktiven Gases, das dazu eingerichtet ist, wechselseitige elektromagnetische und druckmäßige Interaktionen mit dem Target (63a, 63b) zu erzuegen, wobei:
die Quelle für aktive Spezies eine Gasquelle (76, 77) zur Zuführung des reaktiven Gases und eine Energiequelle (80) zur Zuführung von Energie in die Vakuumkammer (21) umfasst, um das reaktive Gas in einen Plasmazustand anzuregen;
das Target (63a, 63b) und die Quelle der aktiven Spezies so angeordnet sind, dass sie dem Substrat (43) gegenüberliegen;
die Energiequelle (80) zwischen sich und der Vakuumkammer (21) ein dielektrisches Fenster zum Zuführen der Energie in die Vakuumkammer (21), einen Gehäusekörper (81) und eine Antenne (85a, 85b) aufweist;
das Target (63a, 63b) und die Quelle der aktiven Spezies so angeordnet sind, dass sie weder räumlich noch druckmäßig getrennt sind;
die Dünnfilm-Ausbildungsvorrichtung eine Sputtervorrichtung vom Inline-Typ ist;
eine Sputterfläche des Targets (63a, 63b), auf der Erosion stattfindet, parallel zu dem Substrat (43) angeordnet ist;
das dielektrische Fenster so angeordnet ist, dass es zur Targetseite hin in einem Winkel von weniger als 90° zu dem Substrat (43) geneigt ist; und
die Antenne (85a, 85b) in einer Antennenaufnahmekammer angeordnet ist und aus einer Spiralspulenelektrode besteht, wobei eine Spiralfläche der Elektrode parallel zu dem dielektrischen Fenster und zu der Bodenfläche des Gehäusekörpers (81) angeordnet ist.

2. Dünnfilm-Ausbildungsvorrichtung nach Anspruch 1, bei der:
ein Substratbeförderungsabschnitt zum Befördern des Substrats (43) innerhalb der Vakuumkammer vorgesehen ist; und
die Quelle der aktiven Spezies auf wenigstens einer der beiden Seiten des Targets (63a, 63b) in einer Substratförderrichtung stromaufwärts oder stromabwärts vorgesehen ist.

3. Dünnfilm-Ausbildungsvorrichtung nach Anspruch 1 oder 2, bei der die Energiequelle (80) eine Plasmaquelle zur Erzeugung von Plasma durch induktive Kopplung und Oberflächenwelle durch das dielektrische Fenster ist.

4. Dünnfilm-Ausbildungsvorrichtung nach einem der Ansprüche 1 bis 3, bei der die Quelle der aktiven Spezies eine Radikalquelle vom Typ Plasma mit induktiver Kopplung (ICP) ist.

5. Dünnfilm-Ausbildungsvorrichtung nach Anspruch 2, weiterhin umfassend eine Sputtervorrichtung vom In-Line-Typ mit einer Vielzahl von Filmausbildungsstationen, die jeweils das Target (63a, 63b) und die Quelle für aktive Spezies umfassen, die auf wenigstens einer der stromaufwärts und stromabwärts gelegenen Seiten des Targets (63a, 63b) in der Substratbeförderungsrichtung angeordnet sind.

6. Dünnfilm-Ausbildungsvorrichtung nach Anspruch 5, bei der die Filmausbildungsstationen jeweils umfassen:
eine Erfassungseinheit zum optischen Erfassen einer Filmabscheidungsrate; und
eine Steuereinheit zum entsprechenden Steuern der Filmabscheidungsrate in jeder Filmausbildungsstation durch Empfang eines Signals von der entsprechenden Filmabscheidungsraten-Erfassungseinheit.

7. Dünnfilm-Ausbildungsvorrichtung nach einem der Ansprüche 1 bis 6, weiterhin umfassend:
einen Sputterabschnitt zum Sputtern des Targets (63a, 63b) und, durch das Sputtern, zum Dispergieren eines Teilchens, das keine vollständige Verbindung ist, von dem Target (63a, 63b) auf das Substrat (43) in der Vakuumkammer (21); und
einen Zusammensetzungs-Umwandlungsabschnitt zum Umwandeln des Teilchens in eine vollständige Metallverbindung durch Kontaktieren des Teilchens mit einer aktiven Spezies eines reaktiven Gases, das durch die Quelle der aktiven Spezies in der Vakuumkammer (21) erzeugt wird, wodurch ein dünner Film, der aus der vollständigen Metallverbindung besteht, auf dem Substrat (43) ausgebildet werden kann.

8. Dünnfilm-Ausbildungsvorrichtung nach Anspruch 1, bei der das Target (63a, 63b) und die Quelle der aktiven Spezies nebeneinander in einem gleichen Raum der Vakuumkammer (21) derart angeordnet sind, dass eine Sputterfläche des Targets (63a, 63b), an der Erosion auftritt, und die Quelle der aktiven Spezies so angeordnet sind, dass sie dem Substrat (43) gegenüberliegen, und die Quelle der aktiven Spezies auf wenigstens einer der stromaufwärts und stromabwärts gelegenen Seiten des Targets in einer Substratförderrichtung angeordnet ist.

9. Dünnfilm-Ausbildungsvorrichtung nach Anspruch 1, bei der das dielektrische Fenster so angeordnet ist, dass es zur Targetseite hin in einem Winkel zwischen 0° und 60° zu dem Substrat (43) geneigt ist, das so angeordnet ist, dass es der Energiequelle (80) in einer Richtung senkrecht zu einer Weiterleitungsrichtung des Substrats (43) gegenüberliegt.

10. Dünnfilm-Ausbildungsvorrichtung nach Anspruch 2, bei der:
die Quelle der aktiven Spezies auf der stromaufwärtigen und stromabwärtigen Seite des Targets (63a, 63b) in der Substratbeförderungsrichtung vorgesehen ist.

11. Dünnfilm-Ausbildungsvorrichtung nach Anspruch 1, weiterhin umfassend:
einen Massendurchflussregler (66, 77) zum Einleiten des Sputtergases und einen Massendurchflussregler zum Einleiten des reaktiven Gases, die unabhängig voneinander installiert sind;
eine Erfassungseinheit zum optischen Erfassen einer Filmabscheidungsrate; und
eine Steuereinheit, die ein Signal von der Erfassungseinheit empfängt und unabhängig voneinander wenigstens eine Sputterleistung, den Massendurchflussregler für das Einleiten des Sputtergases, eine Leistung der Quelle der aktiven Spezies und den Massendurchflussregler für das Einleiten des reaktiven Gases steuert, wodurch die Filmabscheidungsrate gesteuert wird.

12. Dünnfilm-Ausbildungsverfahren, umfassend:
einen Sputterschritt des Sputterns eines Targets (63a, 63b), das aus Metall oder einer leitenden Metallverbindung besteht, wobei das Target (63a, 63b) so angeordnet ist, dass es einem Substrat (43) gegenüberliegt, und durch das Sputtern, Dispergieren eines Teilchens, das keine vollständige Verbindung ist, von dem Target zu dem Substrat (43) in einer Vakuumkammer (21); und
einen Zusammensetzungs-Umwandlungsschritt für das Umwandeln des Teilchens in eine vollständige Metallverbindung in der Vakuumkammer (21) durch Vorsehen eines für die Zuführung der Energie in die Vakuumkammer (21) bestimmten dielektrischen Fensters, das so angeordnet ist, dass es zur Targetseite hin in einem Winkel von weniger als 90° zu dem Substrat (43) geneigt ist, und durch Inkontaktbringen des Teilchens mit einer aktiven Spezies eines reaktiven Gases, das von einer Quelle für aktive Spezies erzeugt wird, die so angeordnet ist, dass sie dem Substrat (43) gegenüberliegt, um die aktive Spezies des reaktiven Gases zu erzeugen, das dazu eingerichtet ist, wechselseitige elektromagnetische und druckmäßige Interaktionen mit dem Target (63a, 63b) zu erzeugen, wodurch ein Dünnfilm, der aus der vollständigen Metallverbindung besteht, auf dem Substrat (43) ausgebildet wird,
wobei das Target (63a, 63b) und die Quelle der aktiven Spezies so angeordnet sind, dass sie weder räumlich noch druckmäßig getrennt sind,
eine Dünnfilm-Ausbildungsvorrichtung, die zum Ausbilden des Dünnfilms verwendet wird, eine Sputtervorrichtung vom In-Line-Typ ist,
eine Sputterfläche des Targets (63a, 63b), auf der Erosion auftritt, parallel zu dem Substrat (43) angeordnet ist, und
die Quelle der aktiven Spezies weiterhin eine Energiequelle (80) zum Zuführen von Energie in die Vakuumkammer (21) umfasst, um das reaktive Gas in einen Plasmazustand anzuregen, die Energiequelle (80) zwischen sich und der Vakuumkammer (21) das dielektrische Fenster zur Zuführung der Energie in die Vakuumkammer (21), einen Gehäusekörper (81) und eine Antenne (85a, 85b) umfasst, wobei die Antenne (85a, 85b) in einer Antennenaufnahmekammer angeordnet ist und aus einer Spiralspulenelektrode besteht und eine Spiralfläche der Elektrode parallel zu dem dielektrischen Fenster und zu der Bodenfläche des Gehäusekörpers (81) angeordnet ist.

13. Dünnfilm-Ausbildungsverfahren nach Anspruch 12, weiterhin umfassend, nach dem Zusammensetzungs-Umwandlungsschritt, einen sich wiederholenden Filmausbildungsschritt, wobei der Sputterschritt und der Zusammensetzungs-Umwandlungsschritt mehrmals parallel wiederholt werden.

14. Dünnfilm-Ausbildungsverfahren nach Anspruch 12 oder 13, weiterhin umfassend:
vor dem Sputterschritt einen Schritt des Einführens des Substrats in die Vorrichtung vom In-Line-Typ mit einer Vielzahl von Filmausbildungsstationen, die jeweils das Target (63a, 63b) und die Quelle der aktiven Spezies enthalten, die auf wenigstens einer der stromaufwärts und stromabwärts gelegenen Seiten des Targets (63a, 63b) in einer Substratbeförderungsrichtung angeordnet sind;
einen stationsinternen Filmausbildungsschritt, wobei der Sputterschritt, der Zusammensetzungs-Umwandlungsschritt und der sich wiederholende Filmausbildungsschritt in den Filmausbildungsstationen ausgeführt werden, während das Substrat (43) mit einer konstanten Geschwindigkeit befördert wird;
einen Beförderungsschritt des Beförderns des Substrates (43) zu den Filmausbildungsstationen auf der stromabwärts gelegenen Seite in der Substratbeförderungsrichtung;
einen Mehrstationen-Filmausbildungsschritt, wobei der stationsinterne Filmausbildungsschritt und der Beförderungsschritt wiederholt werden; und
einen Ausgabeschritt zum Ausgeben des Substrats (43) in die Atmosphäre, nachdem der stationsinterne Filmausbildungsschritt in der Filmausbildungsstation auf einer in der Substratbeförderungsrichtung am weitesten stromabwärts gelegenen Seite abgeschlossen ist.

## Revendications

1. Appareil de formation de film mince destiné à former un film mince d'un composé métallique sur un substrat (43) dans une chambre à vide (21) par pulvérisation cathodique, l'appareil comprenant :
la chambre à vide (21) ;
une cible (63a, 63b), placée dans la chambre à vide (21), composée de métal ou d'un composé métallique conducteur, et
une source d'espèces active, placée dans la chambre à vide (21), destinée à générer une espèce active d'un gaz réactif qui est agencé pour produire des interactions de pression et électromagnétiques réciproques avec la cible (63a, 63b), où :
la source d'espèce active comprend
une source gazeuse (76, 77) destinée à fournir le gaz réactif, et
une source d'énergie (80) destinée à fournir de l'énergie dans la chambre à vide (21) pour exciter le gaz réactif vers un état de plasma ;
la cible (63a, 63b) et la source d'espèce active sont agencées pour être opposées au substrat (43) ;
la source d'énergie (80) comprend, entre elle-même et la chambre à vide (21), une fenêtre diélectrique pour introduire l'énergie dans la chambre à vide (21), un corps de boîtier (81) et une antenne (85a, 85b) ;
la cible (63a, 63b) et la source d'espèce active sont agencées pour n'être pas séparées spatialement ou en termes de pression ;
l'appareil de formation de film mince est un appareil de pulvérisation cathodique de type en ligne ;
une surface de pulvérisation cathodique de la cible (63a, 63b) où se produit une érosion est agencée pour être parallèle au substrat (43) ;
la fenêtre diélectrique est agencée de façon à être inclinée vers le côté de la cible suivant un angle inférieur à 90° par rapport au substrat (43) ; et
l'antenne (85a, 85b) est disposée dans une chambre de stockage d'antenne et consiste en une électrode à bobine spirale, et une face spirale de l'électrode est agencée en parallèle avec la fenêtre diélectrique et la surface inférieure du corps de boîtier (81).

2. Appareil de formation de film mince selon la revendication 1, dans lequel :
une section de transport de substrat destinée à transporter le substrat (43) est placée à l'intérieur de la chambre à vide ; et
la source d'espèce active est placée au moins d'un côté parmi des côtés amont et aval de la cible (63a, 63b) dans un sens de transport du substrat.

3. Appareil de formation de film mince selon la revendication 1 ou 2, dans lequel la source d'énergie (80) est une source de plasma destinée à générer un plasma par couplage inductif et onde de surface à travers la fenêtre diélectrique.

4. Appareil de formation de film mince selon l'une quelconque des revendications 1 à 3, dans lequel la source d'espèce active est une source radicalaire de plasma de type à couplage inductif (ICP).

5. Appareil de formation de film mince selon la revendication 2, comprenant en outre un appareil de pulvérisation cathodique de type en ligne comportant une pluralité de stations de formation de film comprenant chacune la cible (63a, 63b) et la source d'espèce active disposées sur l'un au moins des côtés amont et aval de la cible (63a, 63b) dans le sens de transport du substrat.

6. Appareil de formation de film mince selon la revendication 5,
dans lequel les stations de formation de film comprennent chacune :
une unité de détection pour détecter optiquement une vitesse de dépôt de film ; et
une unité de commande pour commander en conséquence la vitesse de dépôt de film dans chaque station de dépôt de film en recevant un signal de l'unité de détection de vitesse de dépôt de film correspondante.

7. Appareil de formation de film mince selon l'une quelconque des revendications 1 à 6, comprenant en outre :
une section de pulvérisation cathodique destinée à pulvériser la cible (63a, 63b) et, par la pulvérisation cathodique, disperser une particule qui n'est pas un composé entier depuis la cible (63a, 63b) vers le substrat (43) dans la chambre à vide (21) ; et
une section de conversion de composition destinée à convertir la particule en composé métallique entier en mettant en contact la particule avec une espèce active d'un gaz réactif générée par la source d'espèce active dans la chambre à vide (21), ce qui permet de former un film mince constitué du composé métallique entier sur le substrat (43).

8. Appareil de formation de film mince selon la revendication 1, dans lequel la cible (63a, 63b) et la source d'espèce active sont disposées côte à côte dans un même espace de la chambre à vide (21) de façon telle qu'une face de pulvérisation cathodique de la cible (63a, 63b) où se produit une érosion et la source d'espèce active sont agencées pour être opposées au substrat (43), et la source d'espèce active sont disposées d'un côté au moins parmi des côtés amont et aval de la cible dans un sens de transport du substrat.

9. Appareil de formation de film mince selon la revendication 1, dans lequel la fenêtre diélectrique est agencée de façon à être inclinée vers le côté de la cible suivant un angle entre 0° et 60° par rapport au substrat (43) qui est agencé pour être opposé à la source d'énergie (80) dans une direction perpendiculaire à un sens d'avance du substrat (43).

10. Appareil de formation de film mince selon la revendication 2, dans lequel :
la source d'espèce active est placée sur les côtés amont et aval de la cible (63a, 63b) dans le sens de transport du substrat.

11. Appareil de formation de film mince selon la revendication 1, comprenant en outre :
un régulateur de débit massique (66, 77) destiné à introduire le gaz de pulvérisation cathodique, et un régulateur de débit massique destiné à introduire le gaz réactif, qui sont installés de façon indépendante ;
une unité de détection pour détecter optiquement une vitesse de dépôt de film ; et
une unité de commande qui reçoit un signal de l'unité de détection et commande de façon indépendante au moins une puissance de la pulvérisation cathodique, le régulateur de débit massique destiné à introduire le gaz de pulvérisation cathodique, une puissance de la source d'espèce active et le régulateur de débit massique destiné à introduire le gaz réactif, ce qui permet de commander la vitesse de dépôt de film.

12. Procédé de formation d'un film mince comprenant :
une étape de pulvérisation cathodique destinée à pulvériser une cible (63a, 63b) composée de métal ou d'un composé métallique conducteur, la cible étant agencée pour être opposée à un substrat (43), et, par la pulvérisation cathodique, disperser une particule qui n'est pas un composé entier depuis la cible vers le substrat (43) dans une chambre à vide (21) ; et
une étape de conversion de composition destinée à convertir la particule en composé métallique entier dans la chambre à vide (21) en fournissant une fenêtre diélectrique destinée à fournir l'énergie dans la chambre à vide (21) qui est agencée de façon à être inclinée vers le côté de la cible suivant un angle inférieur à 90° par rapport au substrat (43), et en mettant en contact la particule avec une espèce active d'un gaz réactif générée par une source d'espèce active, agencée pour être opposée au substrat (43), destinée à générer l'espèce active du gaz réactif qui est agencé pour produire des interactions de pression et électromagnétiques réciproques avec la cible (63a, 63b), ce qui permet de former un film mince constitué du composé métallique entier sur le substrat (43),
dans lequel
la cible (63a, 63b) et la source d'espèce active sont agencées pour n'être pas séparées spatialement ou en termes de pression,
un appareil de formation de film mince utilisé pour former le film mince est un appareil de pulvérisation cathodique de type en ligne,
une surface de pulvérisation cathodique de la cible (63a, 63b) où se produit une érosion est agencée pour être parallèle au substrat (43), et
la source d'espèce active comprend en outre une source d'énergie (80) destinée à fournir de l'énergie dans la chambre à vide (21) pour exciter le gaz réactif vers un état de plasma, la source d'énergie (80) comprend, entre elle-même et la chambre à vide (21), la fenêtre diélectrique pour introduire l'énergie dans la chambre à vide (21), un corps de boîtier (81) et une antenne (85a, 85b), l'antenne (85a, 85b) est disposée dans une chambre de stockage d'antenne et consiste en une électrode à bobine spirale, et une face spirale de l'électrode est agencée en parallèle avec la fenêtre diélectrique et la surface inférieure du corps de boîtier (81).

13. Procédé de formation de film mince selon la revendication 12, comprenant en outre, après l'étape de conversion de composition, une étape répétitive de formation de film où l'étape de pulvérisation cathodique et l'étape de conversion de composition sont répétées en parallèle une pluralité de fois.

14. Procédé de formation de film mince selon la revendication 12 ou 13, comprenant en outre :
avant l'étape de pulvérisation cathodique, une étape d'introduction du substrat dans l'appareil de type en ligne comportant une pluralité de stations de formation de film comprenant chacune la cible (63a, 63b) et la source d'espèce active disposées d'un côté au moins parmi les côtés amont et aval de la cible (63a, 63b) dans un sens de transport du substrat ;
une étape de formation de film en station, où l'étape de pulvérisation cathodique, l'étape de conversion de composition et l'étape répétitive de formation de film sont exécutées dans les stations de formation de film tandis que le substrat (43) est transporté à une vitesse constante ;
une étape de transport pour transporter le substrat (43) vers les stations de formation de film du côté aval dans le sens de transport du substrat ;
une étape de formation de film en station multiple, où l'étape de formation de film en station et l'étape de transport sont répétées ; et
une étape d'évacuation pour évacuer le substrat (43) vers l'atmosphère après que l'étape de formation de film en station est terminée dans la station de formation de film sur un côté le plus aval dans le sens de transport du substrat.
